# EUROPÄISCHE PATENTSCHRIFT

(11) **EP 1 454 354 B1**
(45) Veröffentlichungstag und Bekanntmachung des Hinweises auf die Patenterteilung: **15.04.2015**
(21) Anmeldenummer: 02779575.6
(22) Anmeldetag: 27.11.2002
(51) Int. Cl.: H01L 21/762, H01L 27/04, H01L 27/12, H01L 21/316, H01L 21/58, H01L 27/08

(54) **SILIZIUMSUBSTRAT MIT EINER ISOLIERSCHICHT MIT TEILGEBIETEN UND ENTSPRECHENDE ANORDNUNG**
SILICON SUBSTRATE HAVING AN INSULATING LAYER, SILICON SUBSTRATE, AND ASSEMBLY OF A SILICON SUBSTRATE WITH AN INSULATING LAYER
SUBSTRAT DE SILICIUM POURVU D'UNE COUCHE ISOLANTE, SUBSTRAT DE SILICIUM ET ASSEMBLAGE D'UN SUBSTRAT DE SILICIUM AVEC UNE COUCHE ISOLANTE

(30) Priorität: 13.12.2001 DE 10161397; 21.12.2001 DE 10163460
(43) Veröffentlichungstag der Anmeldung: 08.09.2004
(73) Patentinhaber: ams AG, 8141 Unterpremstätten (AT)
(72) Erfinder: STÜCKLER, Ewald, A-8141 Unterpremstätten (AT); KOPPITSCH, Günther, A-8501 Lieboch (AT)
(74) Vertreter: Epping - Hermann - Fischer
(86) Internationale Anmeldenummer: PCT/EP2002/013398
(87) Internationale Veröffentlichungsnummer: WO 2003/054955

(56) Entgegenhaltungen:
- US-A- 6 093 599
- PATENT ABSTRACTS OF JAPAN vol. 015, no. 219 (E-1074), 5. Juni 1991 (1991-06-05) -& JP 03 062946 A (MATSUSHITA ELECTRIC IND CO LTD), 19. März 1991 (1991-03-19)
- PATENT ABSTRACTS OF JAPAN vol. 017, no. 375 (E-1397), 14. Juli 1993 (1993-07-14) -& JP 05 063069 A (NIPPONDENSO CO LTD), 12. März 1993 (1993-03-12)
- ERZGRAEBER H B ET AL: "NOVEL BURIED OXIDE ISOLATION FOR MONOLITHIC RF INDUCTORS ON SILICON" INTERNATIONAL ELECTRON DEVICES MEETING 1998. IEDM TECHNICAL DIGEST. SAN FRANCISCO, CA, DEC. 6 - 9, 1998, NEW YORK, NY: IEEE, US, 6. Dezember 1998 (1998-12-06), Seiten 535-539, XP000859430 ISBN: 0-7803-4775-7
- PATENT ABSTRACTS OF JAPAN vol. 009, no. 220 (E-341), 6. September 1985 (1985-09-06) -& JP 60 080244 A (HITACHI SEISAKUSHO KK), 8. Mai 1985 (1985-05-08)

## Beschreibung

Die Erfindung betrifft ein Siliziumsubstrat mit einer Isolierschicht, bei der die Isolierschicht erste Bereiche aufweist, die durch Oxidation von Silizium aus dem Substrat entstandenes Siliziumoxid enthalten und bei der das Substrat zweite Bereiche aufweist, die durch Abscheiden hergestelltes Siliziumoxid enthalten. Die ersten und zweiten Bereiche erstrecken sich entlang von Vorzugsrichtungen. Darüber hinaus betrifft die Erfindung ein Siliziumsubstrat zur Herstellung des Siliziumsubstrats mit einer Isolierschicht. Darüber hinaus betrifft die Erfindung die Anordnung eines Siliziumsubstrats mit einer Isolierschicht.

In der Fertigung monolithischer Schaltkreise besteht mit Fortschreiten zu immer höherfrequenten Anwendungen die Anforderung, passive Schaltungselemente vom Substrat zu entkoppeln. Ein Weg eine derartige Entkopplung zu gewährleisten, besteht darin, eine ausreichend dicke Isolationsschicht zwischen Schaltungselement und Substrat bereitzustellen. Eine solche Isolationsschicht ist bekannt aus Erzgräber, Grabolls, Richter, Schley und Wolf; "A Novel Buried Oxid Isolation for Monolithic RF Inductors on Silicon", IEEE 1998.

Für den großen Bereich der Halbleitertechnologie auf Siliziumbasis bedeutet das, die passiven Schaltelemente wie leitende Verbindungen, Widerstände, Kapazitäten und Induktoren auf einer Isolationsschicht zu realisieren, die niveaugleich zum Siliziumsubstrat, das heißt zu den aktiven Schaltungselementen liegt. Der große Erfolg gerade der Silizium-Halbleitertechnologie beruht auf der Möglichkeit, das halbleitende Silizium durch einen einfachen chemischen Oxidationsschritt in einen Isolator von hoher Qualität, nämlich SiO₂ überzuführen. Damit können kostengünstig, voneinander isoliert arbeitende aktive Halbleiterschaltelemente in hoher Packungsdichte zu elektronischen Systemen integriert werden. Der chemische Prozeß der Oxidation erfolgt üblicherweise bei Atmosphärendruck und bei Temperaturen im Bereich von 800 bis 1150°C. Dabei schreitet die chemische Umwandlung von Si in SiO₂ von der Oberfläche ausgehend in die Tiefe des Siliziumsubstrates fort. Die Zufuhr von Sauerstoff an die Front der chemischen Reaktion erfolgt durch Diffusion. Sich aufbauendes Oxid behindert mit fortschreitender Dicke den Diffusionsprozeß, die Oxidationsgeschwindigkeit nimmt ab und wird zunehmend ineffizient. Oxidschichten wie sie zum Beispiel in CMOS Technologie gängig erzeugt werden, liegen im Bereich von unter 1 *µ*m. Von technologischer Bedeutung ist der Umstand, daß mit der Umwandlung von Si in SiO₂ eine Volumenzunahme einhergeht. Die Stärke der entstandenen Si02 Schicht mißt schließlich zirka das 2,2-fache der Siliziumschicht, aus der sie hervorgegangen ist.

Geometrische Anforderungen an monolithisch integrierten SiO₂-Isolationsschichten sind einerseits ihre Ausdehnung in die Tiefe, wobei mit einigen *µ*m bis einigen 10 *µ*m eine wirksame Entkopplung vom Substrat erreicht wird. Andererseits sind laterale Ausdehnungen von bis zu mehreren mm² notwendig, um passive Bauelemente platzieren zu können. Mit einer planaren Oxidation lassen sich, wie oben erwähnt, wirtschaftlich sinnvoll Oxidtiefen nur von etwa 1 *µ* erzeugen. Für größere Tiefen erzeugt man erst mittels eines anisotropen Ätzprozesses Trench-Strukturen in dem Siliziumsubstrat. Verbleibende Si-Stege können dann in dem Oxidationsprozeß von allen mit Sauerstoff zugänglichen Seiten aus in Oxid umgewandelt werden. Wählt man das Verhältnis von Breite des Steges zur Breite des freigeätzten Spaltes derart, daß nach einer Oxidation die Zwischenräume durch die Volumenzunahme geschlossen sind, hat man den gewünschten Effekt der dicken Isolationsschicht erreicht. Reale Produktionsprozesse lassen sich jedoch nicht beliebig genau kontrollieren. Man erhält eine gewisse Verteilung der Stegbreite über das Werkstück (Siliziumscheibe) und über mehrere Werkstücke mit dem Effekt, daß entweder ein Teil des Spaltes offen bleibt, oder der Steg nicht ganz in Oxid umgewandelt wird. Aus diesem Grund wird das Verhältnis von Steg zu Spalt von vornherein so dimensioniert, daß nach der Oxidation ein Spalt verbleibt, der dann in einem weiteren Prozeßschritt mit Oxid aus einer CVD-Abscheidung aufgefüllt wird. Unterschiede in den thermischen Ausdehnungskoeffizienten zwischen einkristallinem Silizium und SiO₂ sowie die notwendigen Prozeßtemperaturen führen zu mechanischen Spannungen und damit zu Verwerfungen in der Geometrie der Stege. So zeigen zum Beispiel ursprünglich über große Entfernungen parallel angeordnete Stege nach der Oxidation eine Clusterbildung mit einander sich zuneigenden Stegen. Diese grenzen sich durch einen relativ breiten Spalt von dem Nachbarcluster ab. Letztere Spalten sind zu breit um mittels Oxidabscheidung aufgefüllt werden zu können, was nachteilig für die Qualität der entstehenden Isolierschicht ist.

Dokument JP 03-062946 beschreibt einen Halbleiterkörper. Ein trennender Bereich umschließt einen aktiven Bereich. Der trennende Bereich umfasst ein Teilgebiet mit mehreren Stegen entlang einer ersten Vorzugsrichtung und ein weiteres Teilgebiet mit mehreren Stegen entlang einer zweiten Vorzugsrichtung. Die Stege aus einem Halbleitermaterial werden während eines Herstellungsverfahrens oxidiert. Anschließend werden die Gräben zwischen den oxidierten Stegen mit Polysilizium aufgefüllt.

Dokument JP 05-063069 zeigt ein Halbleitersubstrat, das in Teilgebiete eingeteilt ist. In einem Teilgebiet sind jeweils ein breiter und zwei enge Gräben, die mit einem isolierenden Material und Polysilizium gefüllt sind, angeordnet. Ein Teilgebiet einer ersten Art hat eine Vorzugsrichtung, die um 90 Grad zu einer Vorzugsrichtung eines Teilgebietes einer zweiten Art gedreht ist. Die Teilgebiete sind schachbrettartig angeordnet.

Es ist Aufgabe der Erfindung, ein Siliziumsubstrat anzugeben, das eine Isolierschicht mit verbesserten Eigenschaften aufweist. Ferner ist es Aufgabe der Erfindung, ein Siliziumsubstrat anzugeben, das die Herstellung einer Isolierschicht mit verbesserten Eigenschaften ermöglicht.

Diese Aufgaben werden gelöst durch ein Siliziumsubstrat mit einer Isolierschicht nach Patentanspruch 1 sowie durch ein Siliziumsubstrat nach Patentanspruch 3. Vorteilhafte Ausgestaltungen des Siliziumsubstrats mit einer Isolierschicht sowie des Siliziumsubstrats und die Anordnung eines Substrats mit einer Isolierschicht sind den weiteren Ansprüchen zu entnehmen.

Es wird ein Siliziumsubstrat mit einer Isolierschicht angegeben, bei dem die Isolierschicht in Teilgebiete unterteilt ist. Ferner gibt es erste Bereiche, die durch Oxidation von aus dem Substrat stammendem Silizium entstandenes Siliziumoxid enthalten und sich entlang einer Vorzugsrichtung erstrecken. Ferner gibt es zweite Bereiche, die durch Abscheiden hergestelltes Siliziumoxid enthalten und die sich entlang einer Vorzugsrichtung erstrecken. Jedes Teilgebiet enthält wenigstens zwei erste und zwei zweite Bereiche, die abwechselnd nebeneinander entlang einer Vorzugsrichtung des Teilgebiets angeordnet sind. Es ist eine erste Art von Teilgebieten und eine zweite Art von Teilgebieten vorhanden, wobei Teilgebiete derselben Art auch gleiche Vorzugsrichtungen aufweisen und wobei die Vorzugsrichtungen der ersten Art und der zweiten Art von Teilgebieten voneinander verschieden sind und wobei die Teilgebiete im wesentlichen quadratische Umrisse aufweisen und schachbrettartig angeordnet sind.

Durch das Aufteilen der Isolierschicht in Teilgebiete mit verschiedenen Vorzugsrichtungen kann erreicht werden, daß die Isolierschicht ohne die Gefahr des Auftretens von Verwerfungen von Bereichen der Isolierschicht zu erhalten sind. Auch die Bildung von Clustern von sich zueinander zuneigenden Stegen mit dem Problem der mangelhaften Ausfüllbarkeit der entsprechend verbreiterten Gräben mit abgeschiedenem Siliziumoxid kann vermindert werden. Die Gefahr der Entstehung von Nachbarclustern mit breiten Spalten kann vermindert werden.

Es wird dementsprechend ein Siliziumsubstrat angegeben, mit der das oben beschriebene Siliziumsubstrat mit einer Isolierschicht hergestellt werden kann. Das Siliziumsubstrat ist in Teilgebiete unterteilt. Es weist durch Gräben voneinander getrennte Stege auf, die entlang von Vorzugsrichtungen verlaufen. Jedes Teilgebiet weist wenigstens zwei entlang einer Vorzugsrichtung des Teilgebiets verlaufende Stege auf. Ferner ist eine erste Art von Teilgebieten und eine zweite Art von Teilgebieten vorhanden, die im Wesentlichen quadratische Umrisse aufweisen und deren Vorzugsrichtungen voneinander verschieden sind. Die Teilgebiete sind durch entlang deren Umrisse verlaufende Stege getrennt. Die Stege bestehen aus Silizium.

Die zu ein und derselben Art gehörenden Teilgebiete haben dabei zueinander parallele Vorzugsrichtungen.

Es ist darüber hinaus vorteilhaft, wenn die Vorzugsrichtungen verschiedener Arten von Teilgebieten aufeinander senkrecht stehen. Dadurch können die verschiedenen Arten von Teilgebieten auf vorteilhafte Art und Weise hinsichtlich ihrer Vorzugsrichtung klar gegeneinander abgegrenzt werden, was die Ausbildung einer über die Gesamtfläche homogenen Siliziummoxidschicht fördert.

Die Teilgebiete weisen im wesentlichen quadratische Umrisse auf und können schachbrettartig angeordnet sein. Dabei sind entlang von Zeilen und Spalten des Schachbrettmusters jeweils abwechselnd ein Teilgebiet der ersten und ein Teilgebiet der zweiten Art nebeneinander angeordnet.

Die schachbrettartige Anordnung der Teilgebiete ermöglicht eine leicht herzustellende Struktur der Unterteilung des Siliziumsubstrats beziehungsweise der daraus resultierenden Isolierschicht in einem Siliziumsubstrat.

Ferner sind bei einem Siliziumsubstrat die Teilgebiete durch entlang deren Umrisse verlaufende Stege voneinander getrennt. An Kreuzungen von Stegen sind Vertiefungen vorgesehen, die von Ecken beziehungsweise Kanten der benachbarten Gräben in die Stege der Kreuzung hinein verlaufen.

Solche zusätzlichen Vertiefungen haben den Vorteil, daß die Stege an kritischen Stellen, wo sich aufgrund von Kreuzungen eine erhöhte zu oxidierende Silizium-Wandstärke ergäbe, dünner ausgeführt werden können und mithin für eine sehr zuverlässige Oxidation des jeweiligen Stegs gesorgt werden kann.

Darüber hinaus haben die zusätzlichen Vertiefungen den Vorteil, daß sie Abrundungseffekten entgegenwirken, die die photolithographisch hergestellten Gräben betreffen, und die eine Abrundung der äußeren Kanten der Gräben und mithin eine zusätzliche Verstärkung der Wandstärke von Stegen im Bereich von Kreuzungen zur Folge haben.

Es ist des weiteren vorteilhaft, wenn ein zwei Teilgebiete voneinander trennender Steg schmäler ist als die innerhalb der benachbarten Teilgebiete angeordneten Stege.

Die zwei Teilgebiete voneinander trennenden Stege sind besonders von Kreuzungen von Stegen betroffen, weswegen hier ganz besonders darauf geachtet werden muß, daß die Breite des Stegs nicht zu groß ist.

Es wird darüber hinaus eine Anordnung eines Substrats mit einer Isolierschicht angegeben, bei der sich die Isolierschicht von der Oberfläche des Substrats aus nach innen erstreckt. Auf der Oberfläche der Isolierschicht ist ein passives Bauelement angeordnet. Auf der Oberfläche des Substrats neben der Isolierschicht ist ein aktives Bauelement angeordnet. Die Bauelemente sind durch ein Verbindungselement elektrisch leitend miteinander verbunden.

Eine solche Anordnung hat den Vorteil, daß durch die Isolierschicht, die gute isolierende Eigenschaften aufweist und die in hoher Qualität hergestellt werden kann, eine gute Isolierung des passiven Bauelements gegenüber dem halbleitenden Substrat als solchem sowie weiteren auf dem Substrat beziehungsweise in dem Substrat angeordneten elektrischen Bauelementen ermöglicht wird.

Im folgenden wird die Erfindung anhand von Ausführungsbeispielen und den dazugehörigen Figuren näher erläutert.
- Figur 1: zeigt beispielhaft ein Siliziumsubstrat in Draufsicht.
- Figur 2: zeigt beispielhaft ein Siliziumsubstrat mit einer Isolierschicht in Draufsicht.
- Figur 3: zeigt beispielhaft eine Anordnung eines Substrats mit einer Isolierschicht in einem schematischen Querschnitt.

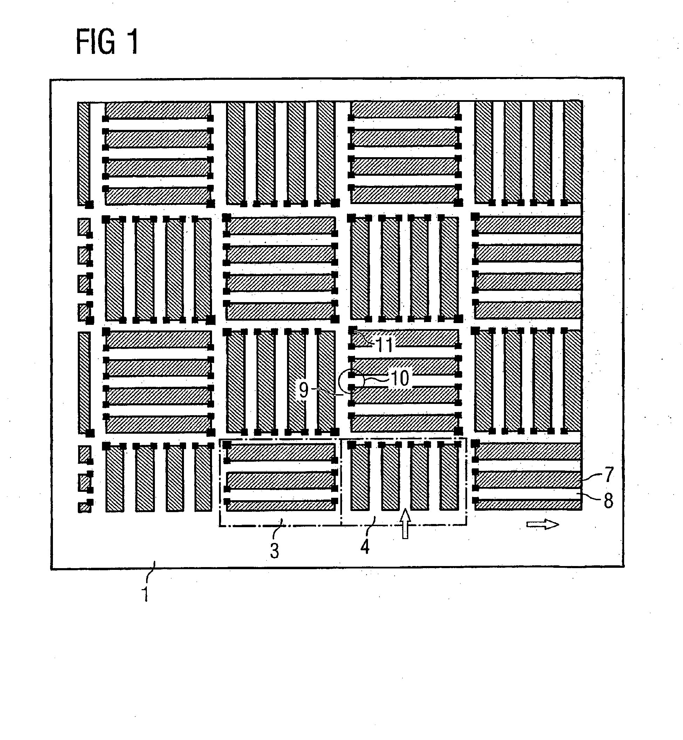

Figur 1 zeigt ein Siliziumsubstrat 1, das in Teilgebiete 3, 4 unterteilt ist. Jedes Teilgebiet 3, 4 enthält durch Gräben 7 voneinander getrennte Stege 8 aus Si. Innerhalb eines Teilgebiets 3, 4 verlaufen die Stege 8 entlang einer Vorzugsrichtung (gekennzeichnet durch Pfeile) des Teilgebiets 3, 4. Es gibt Teilgebiete 3 der ersten Art und es gibt Teilgebiete 4 einer zweiten Art. Die Vorzugsrichtungen der Teilgebiete 3 unterscheiden sich von den Vorzugsrichtungen der Teilgebiete 4. Die Vorzugsrichtungen der Teilgebiete 3 stehen senkrecht auf den Vorzugsrichtungen der Teilgebiete 4. Die Teilgebiete 3, 4 sind näherungsweise in Form von Quadraten ausgeführt, die schachbrettartig auf der Oberfläche des Siliziumsubstrats 1 verteilt sind. Das von dem Schachbrettmuster bedeckte Gebiet kann typischerweise eine Fläche von mehreren Quadratmillimetern auf dem Siliziumsubstrat 1 aufweisen. Die Stege 8 und die Gräben 7 haben eine Breite von vorzugsweise zwischen 0,5 und 1,5 *µ*m. Vorzugsweise sind in jedem Teilgebiet 3, 4 fünf bis sechs Stege 8 angeordnet. Die Teilgebiete 3, 4 können vorzugsweise äußere Abmessungen von 10 bis 15 *µ*m halben. Die Teilgebiete 3, 4 sind durch Stege 9 voneinander getrennt. Im Bereich von Kreuzungen 10 von Stegen 8, 9 sind Vertiefungen 11 vorgesehen, die sich von Ecken beziehungsweise Kanten der den Kreuzungen 10 benachbarten Gräben 7 in die Stege 8 der Kreuzung 10 hinein erstrecken. Die hellen Felder des Schachbrettmusters entsprechen dabei den Teilgebieten 3 der ersten Art. Die dunklen Felder des Schachbrettmusters entsprechen den Teilgebieten 4 einer zweiten Art. Der Steg 9, der zwei Teilgebiete 3, 4 voneinander trennt, ist schmäler ausgeführt als die Stege 8 innerhalb eines der Teilgebiete 3, 4.

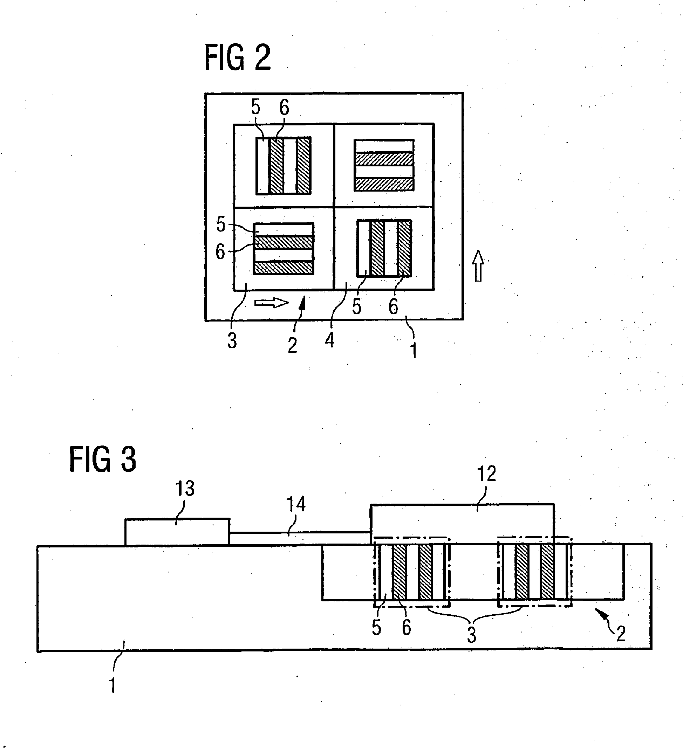

Das Siliziumsubstrat gemäß Figur 1 kann verwendet werden zur Herstellung eines Siliziumsubstrats mit einer Isolierschicht 2 gemäß Figur 2. Dazu wird in einem ersten Schritt das Siliziumsubstrat 1 thermisch oxidiert. Dabei werden die aus Silizium bestehenden Stege 8 mittels Sauerstoff, der von außen zugeführt wird, oxidiert. Die Stege 8 sind so dimensioniert, daß nach dem thermischen Oxidieren die Gräben 7 noch nicht ganz mit Oxid gefüllt sind, und folglich Restgräben bleiben. Diese Restgräben werden anschließend durch in der Gasphase abgeschiedenes Siliziumoxid gefüllt.

Vorzugsweise wird das Silizium in SiO₂ überführt.

Anschließend kann noch ein Sinterschritt zur Anwendung kommen, der eine Verdichtung des abgeschiedenen Oxids bewirkt.

Figur 2 zeigt ein Siliziumsubstrat 1 mit einer Isolierschicht 2, die auf der Oberseite des Siliziumsubstrats 1 hergestellt worden ist. Die Isolierschicht 2 ist unterteilt in Teilgebiete 3 einer ersten Art und in Teilgebiete 4 einer zweiten Art. Dabei weisen benachbarte Teilgebiete 3, 4 voneinander verschiedene, senkrecht aufeinander stehende Vorzugsrichtungen auf (gekennzeichnet durch Pfeile). In jedem Teilgebiet 3, 4 sind erste Bereiche 5 und zweite Bereiche 6 vorhanden. Die ersten Bereiche 5 enthalten durch Oxidation von Silizium aus dem Substrat 1 entstandenes SiO₂ und erstrecken sich entlang der jeweiligen Vorzugsrichtung des Teilgebiets 3, 4.

Die zweiten Bereiche 6 enthalten durch Abscheiden hergestelltes SiO₂ und erstrecken sich ebenfalls entlang der Vorzugsrichtung des entsprechenden Teilgebiets 3, 4.

Figur 3 zeigt die Anordnung eines Siliziumsubstrats 1 mit einer Isolierschicht 2.

Die Isolierschicht 2 ist dabei im Querschnitt gezeigt. Erste Bereiche 5 wechseln sich dabei mit zweiten Bereichen 6 ab. Daraus entsteht ein Linienmuster, das durch einen Querschnitt in eine Isolierschicht 2 gemäß Figur 2 entsteht. Gebiete mit dem Linienmuster aus abwechselnd nebeneinanderliegenden ersten Bereichen 5 und zweiten Bereichen 6 resultieren aus einem Teilgebiet 3 der ersten Art. Neben diesem ersten Linienmuster folgt nach einem relativ unstrukturierten Abschnitt ein zweites Linienmuster, das wiederum aus einem Teilgebiet 3 der ersten Art resultiert. Die zwischen den Linienmustern angeordneten strukturlosen Abschnitte resultieren aus den anderen Teilgebieten 4 der zweiten Art, die in Figur 3 nicht im Querschnitt sondern im Längsschnitt dargestellt sind. Aufgrund des Längsschnitts ergibt sich keine Linienstruktur. Die Isolierschicht 2 erstreckt sich von der Oberseite des Siliziumsubstrats 1 aus in die Tiefe. Auf der Oberfläche der Isolierschicht 2 ist ein passives Bauelement 12 angeordnet. Als passives Bauelement 12 kommt beispielsweise eine Spule in Betracht.

Des weiteren ist neben der Isolierschicht 2 auf der Oberfläche des Siliziumsubstrats 1 ein aktives Bauelement 13 angeordnet. Als aktives Bauelement 13 kommt beispielsweise ein Transistor in Betracht. Das aktive Bauelement 13 und das passive Bauelement 12 sind durch ein Verbindungselement 14 leitend miteinander verbunden. Als Verbindungselement 14 kommt beispielsweise eine Leiterbahn aus Aluminium öder Polysilizium in Betracht.

Aufgrund der durch die Erfindung ermöglichten hochwertigen Isolierschichten 2, die in Form von Inseln in Siliziumsubstraten 1 angeordnet sind, können auf der Oberfläche des Siliziumsubstrats 1 anzuordnende passive Bauelemente 12 gut gegenüber aktiven Bauelementen 13 isoliert werden.

Die vorliegende Erfindung beschränkt sich nicht auf senkrecht aufeinander stehenden Vorzugsrichtungen der ersten Teilgebiete 3 beziehungsweise zweiten Teilgebiete 4. Auch ist die Erfindung nicht beschränkt auf quadratische Teilgebiete 3, 4.

## Patentansprüche

1. Siliziumsubstrat (1) mit einer Isolierschicht (2), die in Teilgebiete (3, 4) unterteilt ist,
- mit ersten Bereichen (5), die durch Oxidation von Silizium aus dem Substrat (1) entstandenes Siliziumoxid enthalten und die sich entlang einer Vorzugsrichtung erstrecken,
- mit zweiten Bereichen (6), die durch Abscheiden hergestelltes Siliziumoxid enthalten und die sich entlang einer Vorzugsrichtung erstrecken,
- bei dem jedes Teilgebiet (3, 4) wenigstens zwei erste Bereiche (5) und zwei zweite Bereiche (6) enthält, die abwechselnd nebeneinander entlang einer Vorzugsrichtung des Teilgebiets (3, 4) angeordnet sind,
- und bei dem Teilgebiete (3) einer ersten Art und Teilgebiete (4) einer zweiten Art vorhanden sind, deren Vorzugsrichtungen voneinander verschieden sind,
wobei die Teilgebiete (3, 4) im wesentlichen quadratische Umrisse aufweisen und schachbrettartig angeordnet sind.

2. Siliziumsubstrat nach Anspruch 1,
bei dem die Vorzugsrichtungen der ersten und zweiten Art von Teilgebieten (3, 4) aufeinander senkrecht stehen.

3. Siliziumsubstrat (1) zur Herstellung eines Siliziumsubstrats mit einer Isolierschicht,
- das in Teilgebiete (3, 4) unterteilt ist,
- bei dem jedes Teilgebiet durch Gräben (7) voneinander getrennte Stege (8) aufweist, die entlang einer Vorzugsrichtung des Teilgebiets (3, 4) verlaufen,
- bei dem jedes Teilgebiet (3, 4) wenigstens zwei entlang einer Vorzugsrichtung des Teilgebiets (3, 4) verlaufende Stege (8) enthält,
- bei dem Teilgebiete (3) einer ersten Art und Teilgebiete (4) einer zweiten Art vorhanden sind, deren Vorzugsrichtungen voneinander verschieden sind,
- und bei dem die Teilgebiete (3, 4) im wesentlichen quadratische Umrisse aufweisen,
wobei die Teilgebiete (3, 4) durch entlang deren Umrisse verlaufende Stege (9) voneinander getrennt sind und wobei die Stege (8, 9) aus Silizium bestehen.

4. Siliziumsubstrat (1) nach Anspruch 3,
bei dem die Vorzugsrichtungen der ersten und zweiten Art von Teilgebieten (3, 4) aufeinander senkrecht stehen.

5. Siliziumsubstrat nach einem der Ansprüche 3 oder 4,
bei dem die Teilgebiete (3, 4) schachbrettartig angeordnet sind.

6. Siliziumsubstrat nach einem der Ansprüche 3 bis 5,
bei dem an Kreuzungen (10) von Stegen (8, 9) Vertiefungen (11) vorgesehen sind, die von Ecken beziehungsweise Kanten benachbarter Gräben (7) aus in die Stege (8, 9) der Kreuzung (10) hinein verlaufen.

7. Siliziumsubstrat nach Anspruch 6,
bei dem die zwei Teilgebiete (3, 4) trennenden Stege (9) schmäler sind als innerhalb der Teilgebiete (3, 4) angeordnete Stege (8).

8. Anordnung eines Siliziumsubstrats (1) mit einer Isolierschicht (2),
- mit einem Siliziumsubstrat (1) nach Anspruch 1 oder 2,
- bei der die Isolierschicht (2) von der Oberfläche des Siliziumsubstrats (1) nach innen ragt,
- bei der auf der Oberfläche der Isolierschicht (2) ein passives Bauelement (12) angeordnet ist,
- bei der auf der Oberfläche des Siliziumsubstrats (1) neben der Isolierschicht (2) ein aktives Bauelement (13) angeordnet ist, und
- bei der die Bauelemente (12, 13) durch ein Verbindungselement (14) miteinander elektrisch leitend verbunden sind.

## Claims

1. A silicon substrate (1) comprising an insulating layer (2) which is partitioned in subareas (3, 4),
- comprising first areas (5) which contain silicon oxide that has been formed by oxidation of silicon from the substrate (1) and extend along a preferential direction,
- comprising second areas (6) which contain silicon oxide that has been produced by deposition and extend along a preferential direction,
- in which each subarea (3, 4) comprises at least two first areas (5) and two second areas (6), which are alternatingly arranged side by side along a preferential direction of the subarea (3, 4),
- and in which there are subareas (3) of a first kind and subareas (4) of a second kind, whose preferential directions differ from each other,
wherein the subareas (3, 4) comprise substantially square outlines and are arranged in a checkered way.

2. The silicon substrate according to claim 1,
in which the preferential directions of the first and second kind of subareas (3, 4) are perpendicular to each other.

3. A silicon substrate (1) for producing a silicon substrate comprising an insulation layer,
- which is partitioned in subareas (3, 4),
- in which each subarea comprises webs (8) which are separated from one another by trenches (7) and extend along a preferential direction of the subarea (3, 4),
- in which each subarea (3, 4) comprises at least two webs (8) extending along a preferential direction of the subarea (3, 4),
- in which there are subareas (3) of a first kind and subareas (4) of a second kind, whose preferential directions differ from each other,
- and in which the subareas (3, 4) comprise substantially square outlines,
wherein the subareas (3, 4) are separated from one another by webs (9) extending along their outlines and
in which the webs (8, 9) are made of silicon.

4. The silicon substrate (1) according to claim 3,
in which the preferential directions of the first and second kind of subareas (3, 4) are perpendicular to each other.

5. The silicon substrate according to any of claims 3 or 4,
in which the subareas (3, 4) are arranged in a checkered way.

6. The silicon substrate according to any of claims 3 to 5,
in which indentations (11) are provided at intersections (10) of webs (8, 9), said indentations extending from corners or edges of neighboring trenches (7) into the webs (8, 9) of the intersection (10).

7. The silicon substrate according to claim 6,
in which the webs (9) separating the two subareas (3, 4) are narrower than webs (8) which are arranged within the subareas (3, 4).

8. An array of a silicon substrate (1) comprising an insulating layer (2),
- comprising a silicon substrate (1) according to claim 1 or 2,
- in which the insulating layer (2) protrudes toward inside from the surface of the silicon substrate (1),
- in which a passive component (12) is arranged on the surface of the insulating layer (2),
- in which an active component (13) is arranged on the surface of the silicon substrate (1) next to the insulating layer (2), and
- in which the components (12, 13) are connected to each other by a connecting element (14) in an electrically conductive manner.

## Revendications

1. Substrat de silicium (1) comportant une couche isolante (2), laquelle est subdivisée en secteurs partiels (3, 4),
- comportant des premiers secteurs (5) qui contiennent de l'oxyde de silicium formé par oxydation de silicium à partir du substrat (1) et qui s'étendent le long d'une direction privilégiée,
- comportant des deuxièmes secteurs (6) qui contiennent de l'oxyde de silicium fabriqué par précipitation et qui s'étendent le long d'une direction privilégiée,
- dans lequel chaque secteur partiel (3, 4) contient au moins deux premiers secteurs (5) et deux deuxièmes secteurs (6) qui sont disposés en alternance les uns à côtés des autres le long d'une direction privilégiée du secteur partiel (3, 4),
- et dans lequel des secteurs partiels (3) d'un premier type et des secteurs partiels (4) d'un deuxième type sont présents, dont les directions privilégiées sont différentes l'une de l'autre,
sachant que les secteurs partiels (3, 4) présentent des contours sensiblement carrés et sont disposés en échiquier.

2. Substrat de silicium selon la revendication 1,
dans lequel les directions privilégiées du premier et du deuxième type de secteurs partiels (3, 4) sont perpendiculaires entre elles.

3. Substrat de silicium (1) pour la fabrication d'un substrat de silicium comportant une couche isolante,
- qui est subdivisée en secteurs partiels (3, 4),
- dans lequel chaque secteur partiel présente des nervures (8) séparées entre elles par des fossés (7) et passant le long d'une direction privilégiée du secteur partiel (3, 4),
- dans lequel chaque secteur partiel (3, 4) contient au moins deux nervures (8) passant le long d'une direction privilégiée d'un secteur partiel (3, 4),
- dans lequel des secteurs partiels (3) d'un premier type et des secteurs partiels (4) d'un deuxième type sont présents, dont les directions privilégiées sont différentes l'une de l'autre,
- et dans lequel les secteurs partiels (3, 4) présentent des contours sensiblement carrés,
sachant que les secteurs partiels (3, 4) sont séparés les uns des autres par des nervures (9) passant le long de leurs contours et sachant que les nervures (8, 9) sont composées de silicium.

4. Substrat de silicium (1) selon la revendication 3,
dans lequel les directions privilégiées du premier et du deuxième type de secteurs partiels (3, 4) sont perpendiculaires entre elles.

5. Substrat de silicium selon l'une des revendications 3 ou 4,
dans lequel les secteurs partiels (3, 4) sont disposés en échiquier.

6. Substrat de silicium selon l'une des revendications 3 à 5,
dans lequel, au niveau de croisements (10) de nervures (8, 9), des évidements (11) sont prévus qui s'avancent dans les nervures (8, 9) du croisement (10) à partir de coins ou de bords de fossés (7) voisins.

7. Substrat de silicium selon la revendication 6,
dans lequel les nervures (9) séparant deux secteurs partiels (3, 4) sont plus étroites que des nervures (8) disposées à l'intérieur des secteurs partiels (3, 4).

8. Disposition d'un substrat de silicium (1) comportant une couche isolante (2),
- comportant un substrat de silicium (1) selon la revendication 1 ou 2,
- dans laquelle la couche isolante (2) dépasse de la surface du substrat de silicium (1) vers l'intérieur,
- dans laquelle un composant passif (12) est disposé sur la surface de la couche isolante (2),
- dans laquelle un composant actif (13) est disposé sur la surface du substrat de silicium (1) à côté de la couche isolante (2), et
- dans laquelle les composants (12, 13) sont reliés entre eux de manière électriquement conductrice par un élément de liaison (14).
